# EUROPEAN PATENT APPLICATION

(11) **EP 3 226 040 A1**
(43) Date of publication of application: **04.10.2017**
(21) Application number: 14907948.5
(22) Date of filing: 10.12.2014
(51) Int. Cl.: G02B 3/08, G01V 8/10

(54) **ELECTROMAGNETIC RADIATION SENSING SYSTEM**

(71) Applicant: Bolymedia Holdings Co. Ltd., Santa Clara, California 95051 (US)
(72) Inventor: HU, Xiaoping, Shenzhen Guangdong 518055 (CN)
(74) Representative: Manitz Finsterwald Patentanwälte PartmbB
(86) International application number: PCT/CN2014/093454
(87) International publication number: WO 2016/090570

(57) **Abstract**

An electromagnetic radiation sensing system, comprising sensing elements (604, 605, 606) and a Fresnel lens system for converging electromagnetic radiation; the sensing elements (604, 605, 606) are used to sense the electromagnetic radiation converged by the Fresnel lens system; the Fresnel lens system comprises at least two toothed faces (601, 602, 603) located on the same light path, each of the tooth faces comprising at least one Fresnel unit; at least one of the two toothed faces is a complex Fresnel refraction surface or a filled Fresnel refraction surface, or the two tooth faces are at a same physical interface and an element located thereon has a reflective back surface. The electromagnetic radiation sensing system can adequately utilize the advantage of the thinness of a Fresnel lens, and has better convergence without a significant increase in the thickness of the system, thus facilitating reducing of the size of a device and improving of the system performance.

## Description

### TECHNICAL FIELD

The present disclosure relates to absorption and conversion of energy of electromagnetic radiation, specifically to an electromagnetic radiation sensing system.

### BACKGROUND

The term "electromagnetic radiation" as used herein has the broad meaning, and can be classified according to their wavelength range and signal source. For example, it can be solar radiation, radar radiation, gamma rays, microwaves, infrared radiation, radio waves or X-ray, etc. The technologies for absorbing and converting the energy of the electromagnetic radiation are widely used in many areas, such as radar warning, astronomical observation, radio signal transmission and solar power generation, etc. In these applications, enhancing the energy of the signal to be sensed and/or increasing the energy conversion efficiency is always the pursuit of the goal. A common practice is to converge the electromagnetic radiation. On one hand, the signal can be enhanced; on the other hand, the size of the sensing element can be reduced.

Fresnel lens is a thin lens. A Fresnel lens may be obtained by segmenting a continuous curved surface of an ordinary lens into a plurality of segments and arranging, after reducing the thickness of each segment, the segments on a same plane or on a substantially smooth curved surface. The refraction surface of the Fresnel lens is generally discontinuously stepped or dentate. In the present disclosure, the curved surfaces (non-smooth surfaces) of the lens are referred to as refraction surfaces.

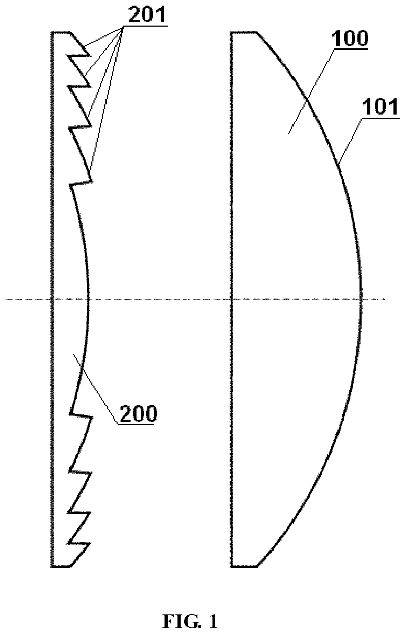

FIG. 1 shows an ordinary configuration of the Fresnel lens. In FIG. 1, the dash line represents the center of the curved surface. The original curved surface 101 of an ordinary lens 100 may be segmented into a plurality of concentric lens rings 201. After the thickness of each lens ring is reduced, the plurality of lens rings may be arranged on a same plane to form a Fresnel lens 200. Such discontinuous refraction surface evolved from the original curved surface may be referred to as Fresnel refraction surface. Since the refraction of light occurs on the curved surface of the lens and is independent of the thickness of the lens, the Fresnel refraction surface theoretically has optical performance similar to that of corresponding original curved surface, but with greatly reduced thickness. The reduction in thickness can reduce the absorption and attenuation of light energy, which is an important advantage of the Fresnel lens in many applications.

The Fresnel refraction surface generated from one original curved surface may be referred to as one Fresnel unit. A Fresnel unit may be described using five groups of basic parameters: center location, area, focal length, refraction surface shape, and locations and number of segmentation rings.

For simplicity, in the present disclosure, the side on which the Fresnel refraction surfaces are arranged is referred to as "tooth side", the other side which is relatively smooth and flat is referred to as "back side", and the Fresnel lens which has a tooth side on one side and a back side on the other side is referred to as "single-sided Fresnel lens".

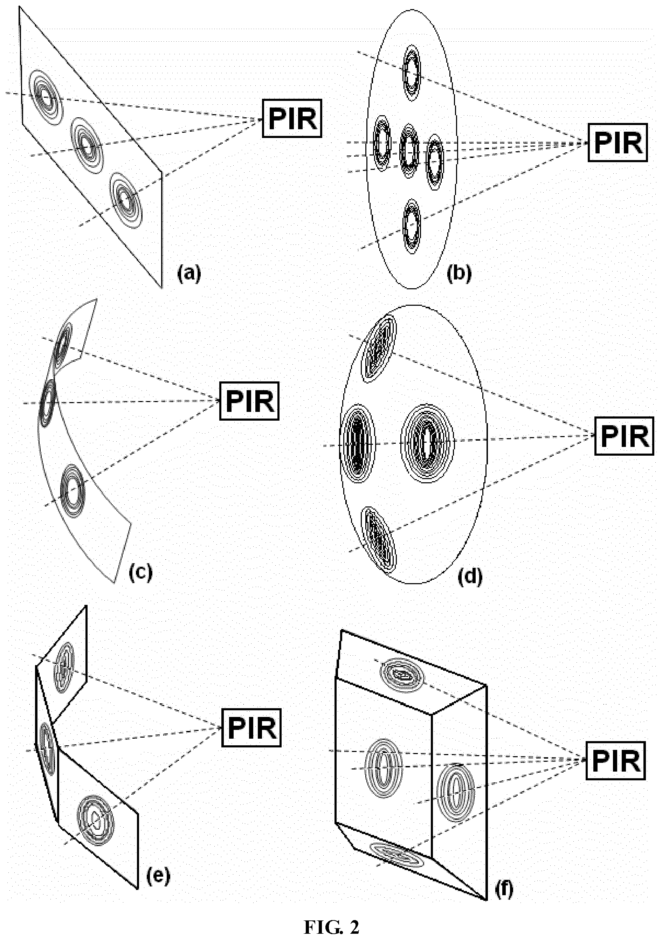

Fresnel lens can be used for converging optical signal, such as infrared, so as to facilitate the detection by the sensing element, such as the passive infrared detector "PIR" shown in FIG. 2. Obviously, the Fresnel lens can also be used for converging other types of electromagnetic radiation.

The focus range of single Fresnel unit is limited. In order to increase the signal sensing range, it is also possible to arranging a plurality of Fresnel units on the tooth side. The tooth side on which only one Fresnel unit is arranged may be referred to as "simple Fresnel refraction surface". The single-sided Fresnel lens using such tooth side may be referred to as "single-sided simple Fresnel lens". Correspondingly, the tooth side on which two or more Fresnel units are arranged may be referred to as "composite Fresnel refraction surface", and the single-sided Fresnel lens using such tooth side may be referred to as "single-sided composite Fresnel lens".

The back side of the single-sided composite Fresnel lens is generally a macroscopic surface, such as plane, coaxial surface (including rotation surface, such as sphere, ellipsoid, cylindrical surface, parabolic cylindrical surface, hyperbolic cylindrical surface and high order polynomial surface, etc.), multi-plane surface formed by splicing a plurality of planes, and trapezoidal table surface, etc. FIG. 2 shows the configuration of several single-sided composite Fresnel lens, where the dash lines represents the light paths passing through the centers of the Fresnel units. In FIG. 2(a), the tooth side includes three Fresnel units arranged horizontally, and the back side is a plane (rectangular). In FIG. 2(b), the tooth side includes five Fresnel units, one of which is located at the center and the other four are distributed around, and the back side is a plane (circular). In FIG. 2(c), the back side is a circular cylindrical surface. In FIG. 2(d), the back side is a sphere. In FIG. 2(e), the back side is a multi-plane surface formed by splicing three planes. In FIG. 2(f), the back side is a trapezoidal table surface.

It is a worthwhile research direction to develop the Fresnel lens system and use the Fresnel lens system to improve the performance of the electromagnetic radiation sensing system.

### SUMMARY

The present disclosure provides an electromagnetic radiation sensing system which may include a sensing element and a Fresnel lens system used for converging the electromagnetic radiation. The sensing element may be used to sense the electromagnetic radiation converged by the Fresnel lens system. The Fresenl lens system may include at least two toothed faces located on a same light path. Each toothed face may include at least one Fresenl unit, and each Fresenl unit may be a Fresnel refraction surface generated from one original curved surface. At least one of the two toothed faces may be a complex Fresnel refraction surface or a filled Fresnel refraction surface. Or, the two toothed faces may be a same physical interface, and the element on which the two toothed faces are located may have a reflective back face.

The Fresnel lens system according to the present disclosure may be implemented in a variety of excellent forms. The two toothed faces included in the Fresnel lens system may be arranged on two separate elements, or may also be combined together back to back to become two sides of a double-sided Fresnel lens. Furthermore, the Fresnel lens system may also preferably converge the electromagnetic radiation to different focal planes according to spectral bands such that the sensing element arranged correspondingly can sense the electromagnetic radiation according to the spectral bands.

The electromagnetic radiation sensing system according to the present disclosure use the Fresenl lens system which may have two or more toothed faces. Therefore, the advantage of thin thickness of the Fresnel lens may be fully utilized, and stronger convergence ability may be achieved without significant increase in system thickness. The increased convergence ability can reduce the focal length and the area of the sensing element, which can facilitate the reduction in the size of the device and the increase in the performance of the system. Furthermore, based on the various preferred solutions proposed by the present disclosure, the configurations and use forms of the traditional electromagnetic radiation sensing system can be greatly enriched and expanded.

The specific embodiments according to the present disclosure will be described in details below with reference to the drawings.

### BRIEF DESCRIPTION OF THE DRAWINGS

FIG. 1 schematically shows the configuration of an existing Fresnel lens;
FIG. 2 schematically shows the configuration of several existing single-sided composite Fresnel lenses;
FIG. 3 schematically shows two coaxial surfaces used for generating the Fresnel refraction surfaces according to the present disclosure;
FIG. 4 schematically shows the filled Fresnel refraction surface according to the present disclosure;
FIG. 5 schematically shows the concentric arrangement of the Fresnel units on the two tooth sides according to the present disclosure;
FIG. 6 schematically shows the staggered arrangement of the Fresnel units on the two tooth sides according to the present disclosure;
FIG. 7 schematically shows the back-to-back combination configuration of the two tooth sides according to the present disclosure;
FIG. 8 schematically shows the configuration of the reflective Fresnel lens according to the present disclosure;
FIG. 9 schematically shows the configuration of the electromagnetic radiation sensing system of embodiment 1;
FIG. 10 schematically shows the configuration of the electromagnetic radiation sensing system of embodiment 2;
FIG. 11 schematically shows two ways for dividing the spectral segments according to the present disclosure;
FIG. 12 schematically shows the configuration of the electromagnetic radiation sensing system of embodiment 3; and
FIG. 13 schematically shows the configuration of the electromagnetic radiation sensing system of embodiment 4.

### DETAILED DESCRIPTION

The electromagnetic radiation sensing system according to the present disclosure may include a sensing element and a Fresnel lens system used for converging the electromagnetic radiation. The sensing element may be used to sense the electromagnetic radiation converged by the Fresnel lens system. The sensing element herein may refer to the functional unit which is able to absorb or convert the energy of the electromagnetic radiation. Based on different application requirements, the sensing element may be, for example, photosensitive chip (such as CCD or CMOS), energy detector (such as passive infrared detector or radar detector), photoelectric conversion unit (such as photovoltaic panel) or radio receiving unit, etc.

The Fresnel lens systems according to the present disclosure have at least two tooth sides located on the same optical path. Therefore, they can be referred to as "multi-sided Fresnel lens system". Based on the number of the tooth sides located on the same optical path, they can specifically be referred to as "double-sided Fresnel lens system", "three-sided Fresnel lens system" or the like. In the lens system according to the present disclosure, there may be one or more elements. Based on the number of the tooth sides arranged on a single element, they can similarly be referred to as "single-sided Fresnel lens", "double-sided Fresnel lens" or the like.

It should be noted that there is difference between "double-sided Fresnel lens system" and "double-sided Fresnel lens". The double-sided Fresnel lens refers to a lens whose both sides are tooth sides, while the double-sided Fresnel lens system may be formed by one double-sided Fresnel lens or two single-sided Fresnel lens systems.

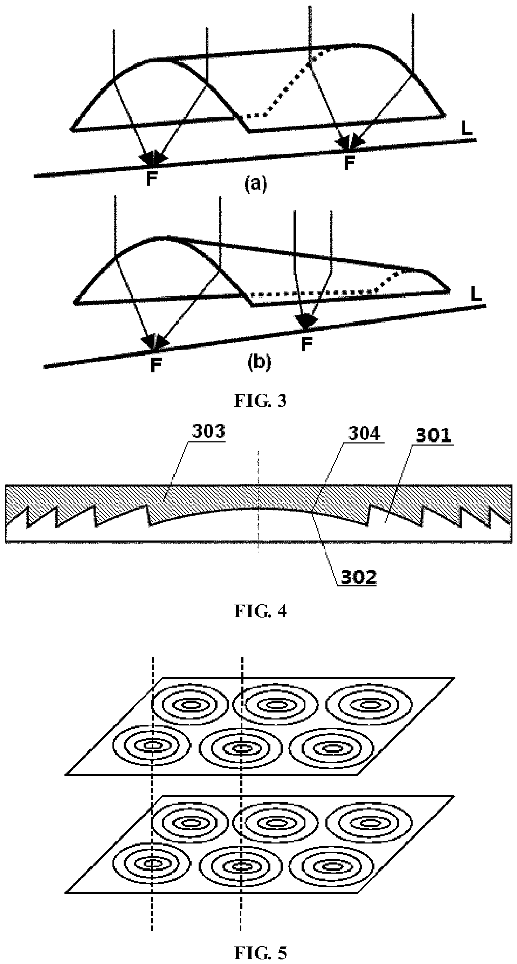

Each tooth side in the system may include at least one Fresnel unit. Each Fresnel unit may be the Fresnel refraction surfaces generated from one original curved surface. Traditional original curved surface used for generating the Fresnel refraction surfaces is generally symmetrical curved surface around the optical axis, for example, rotation surface such as sphere, rotation paraboloid or the like. The focus of the traditional original curved surface is located at one point, and therefore the traditional original curved surface may be referred to as "co-point surface". In the present disclosure, the original curved surface may be any coaxial surface, and may be set according to the requirements of the application. The coaxial surface herein may refer to the curved surface whose focuses are located on a same straight line (not necessarily on a same point). Such straight line may be referred to as "coaxial line". The traditional co-point surface may be considered as a special case where the coaxial line of the coaxial surface is degenerated into one point. Using the original curved surface which is coaxial but not co-point, the sensing device arranged at the focus position can be extended from a small area (corresponding to the focus) to a elongated shape (corresponding to the coaxial line formed by the focuses), thereby increasing the signal collection capability and facilitating to solve the issue of local overheating without significant increase in cost. Typical coaxial surface may include rotation curved surface (including secondary or higher order rotation curved surface), cylindrical surface or tapered surface, etc. The cylindrical surface may also be referred to as equal-section coaxial surface. The shape and size of the cross section obtained by cutting such surface at any point in the direction perpendicular to the coaxial line are the same. The circular cylindrical surface is a special case of the cylindrical surface. The cross sections of the tapered surface along the coaxial line have similar shape, but different size. The circular tapered surface is a special case of the tapered surface. FIG. 3 shows the two coaxial surfaces above, where, FIG. 3(a) shows the equal-section coaxial surface, FIG. 3(b) shows the tapered coaxial surface, and their focuses F are located on respective coaxial line L, respectively.

The single tooth side may be the composite Fresnel refraction surface including two or more Fresnel units. Generally, the basic parameters (for example, area, focal length, the shape of corresponding original curved surface, number of concentric rings, etc.) of the Fresnel units on the composite Fresnel refraction surface may be set flexibly, and may be all the same, partially the same or all different. In an embodiment, each Fresnel unit on the composite Fresnel refraction surface may have its own optical center, but the focuses may be located at the same point, on one straight line or within a limited area. This may be implemented by spatially arranging each of the Fresnel units forming the composite Fresnel refraction surface. It can be considered that these Fresnel units are arranged on a macroscopic surface, such as plane, quadratic surface (including sphere, ellipsoid, circular cylindrical surface, parabolic cylindrical surface and hyperbolic cylindrical surface), high order polynomial surface (an ordinary way for implementing an aspherical surface), multi-plane surface formed by splicing a plurality of planes, and trapezoidal table surface, etc.

The single tooth side may also be filled Fresnel refraction surface. The filled Fresnel refraction surface herein may be formed by filling transparent materials on a Fresnel refraction surface (which may be referred to as "mother surface") formed by solid material. The Fresnel refraction surface formed by the filled transparent materials may be referred to as "child surface". The shape of the child surface may be completely complementary to the mother surface. The refractive index of the material used to form the child surface may be different from that of the material used to form the mother surface. Of course, the refractive index of the material used to form the child surface may also be different from that of surroundings (for example, atmosphere). The filling materials used to form the child surface may be selected from solid, liquid or gas material. The solid filling material may be, for example, acrylic, plastic or resin. The liquid filling material may be, for example, water. The gas filling material may be, for example, inert gas.

Referring to FIG. 4, a Fresnel unit with a convex surface 302 may be formed by material 301, and a Fresnel unit with a concave surface 304 may be formed by material 303. The two Fresnel units may be completely complementary to each other in shape, and form a tooth side by a close fit face to face. The Fresnel lens formed by the material 301 may be referred to as "mother lens". The mother lens may be enclosed into a cavity which has a space at the upper part and is transparent. And then, the transparent material 303 may be filled into the cavity, thereby obtaining another Fresnel lens which is completely opposite in concave and convex nature and may be referred to as "child lens".

The configuration of the filled Fresnel refraction surface enables that different focus ability can be obtained by adjusting the refractive indexes of the materials at both sides of the tooth side, and therefore more flexibility may be provided for the optical design of the Fresnel lens system and the cost may be reduced. In an embodiment, the material 301 and the material 303 are different solid material, by which the Fresnel units are formed respectively and closely fitted together. The solid filled Fresnel lens and two traditional Fresnel lenses closely fitted together face to face are the same in configuration, but different in processing process, processing difficulty and thereby requirements to the materials (of mother lens and child lens). In another preferred embodiment, the material 301 may be solid and the material 303 may be liquid or gas. The Fresnel unit may be formed with the solid material 301 first, then the liquid or gas material 303 may be filled on the tooth side and packaged, thereby forming the filled Fresnel refraction surface. Using this method, the processing of one Fresnel unit may be omitted. The used liquid filling material may be, for example, water. The used gas may be inert gas, such as nitrogen. Using liquid to form the filled Fresnel refraction surface has many advantages. On one hand, the heating or cooling of the lens may be easily achieved through the liquid; on the other hand, the liquid is able to be seamlessly combined with the Fresnel unit formed by the solid material to easily overcome the shortcomings of easily producing glare of the Fresnel lens, such that the Fresnel lens system can be used for high-resolution imaging system, such as the lens of digital camera and mobile phone. The glare of the traditional Fresnel lens is generally caused by the discontinuity of the tooth side of the Fresnel lens. Such discontinuity can be compensated by complementary liquid or gas lens, thereby greatly reducing the glare. Using such filled Fresnel lens formed by filling liquid or gas in the first level lens of the wide-angle lens can greatly reduce the size of the lens.

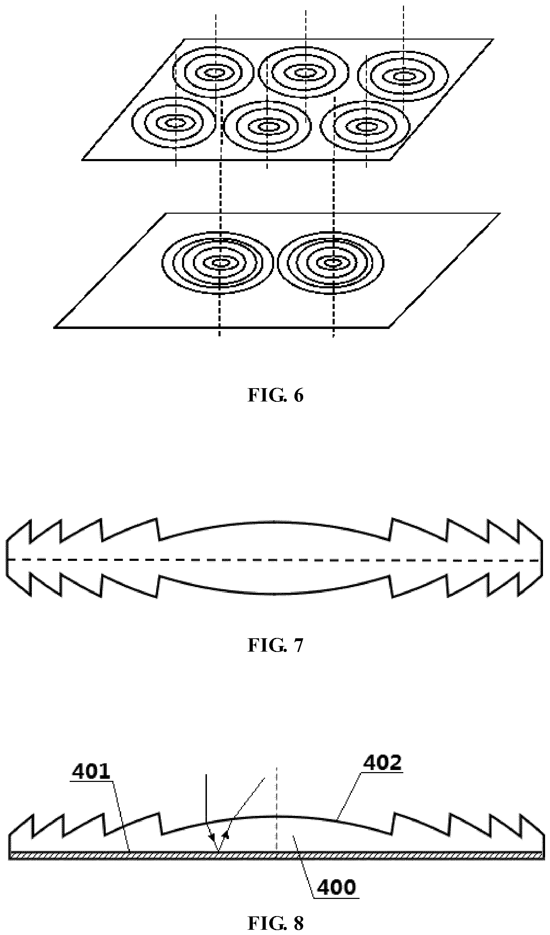

The relative position of the Fresnel units on the two tooth sides may be arranged in two preferred arrangement. One arrangement is shown in FIG. 5, where the Fresnel units on the two tooth sides are the same in number and are arranged concentrically. The concentric arrangement may refer to that the optical axes of each two Fresnel units on the two tooth sides coincide with each other. The other basic parameters (for example, the focal length, the shape of corresponding original curved surface and the number of concentric rings, etc.) of the Fresnel units may or may not be the same, and may be set according to the requirements of the optical design. In FIG. 5, two optical axes are schematically shown in dash lines, and each optical axis corresponds to one Fresnel unit on one tooth side and one Fresnel unit on the other tooth side. The advantage of the concentric arrangement is that the signal near the center of the Fresnel unit can be enhanced. Another arrangement is shown in FIG. 6, where the Fresnel units on the two tooth sides are different in number and arranged in a staggered manner. The staggered arrangement may preferably have the same stagger distances. The staggered arrangement may refer to that the optical axes of the Fresnel units on the two tooth side are staggered with each other. Having the same stagger distances may refer to that the distances between the optical axis of a certain Fresnel unit on one tooth side and the optical axes of several Fresnel units which surround said optical axis on the other tooth side are the same. In FIG. 6, the optical axes are represented by dash lines. The optical axis of one Fresnel unit on the tooth side below is located at the center of the axes of four Fresnel units on the tooth side above. The advantage of the staggered and equidistant arrangement is that the signal can be equalized such that dead space and blind spot in the sensing range can be reduced.

Generally, two or more tooth sides may be combined flexibly to form one or more elements. For example, the composite Fresnel refraction surface may be used in a single-sided element to form the single-sided composite Fresnel lens, such as those shown in FIG. 2. The single-sided composite Fresnel lens may also be considered as being formed by arranging the back sides of two or more single-sided simple Fresnel lenses on one macroscopic surface. In an embodiment, two tooth sides may be located respectively on two separate elements to form a system formed by two single-sided Fresnel lenses. The orientation between the two elements may be tooth side to tooth side, tooth side to back side, or back side to back side. In another embodiment, referring to FIG. 7, the two tooth sides may be arranged on the same element in a back-to-back manner. The part of the two tooth sides may be formed with the same or different materials. Therefore, the dividing line in FIG. 7 is represented with dash line. In the case that two Fresnel lenses in back-to-back form are formed with the same materials, a double-sided Fresnel lens is formed, and can be made by one-piece molding, for example by die using acrylic, resin or other plastic materials. The concave and convex nature of the two tooth sides may be the same or be different. In another embodiment, the system may have three tooth sides, where one is used for a single-sided element and the other two are formed as a double-sided Fresnel lens in back-to-back form. In other embodiments, the configuration described above may also be combined and extended based on needs.

It should be recognized that the two tooth sides of the system may be implemented by the same physical interface through arranging reflective surface. Referring to FIG. 8, the element 400 may be provided with a reflective back side 401 (the inner surface is mirror). The back side 401 may be formed by, for example, plating a reflective film or bonding patches with reflective capability on the smooth surface of the single-sided Fresnel lens or other ways. Because of the reflection, the incident light path may pass through the physical refraction interface 402 twice. Therefore, such physical interface may equivalent to two tooth sides. The element 400 may also be referred to as reflective double-sided Fresnel lens, and the concave and convex nature of the two tooth sides may be the same. By arranging the reflective back side, the number of the tooth sides in the light path may be simply increased, the production cost and installation cost may be reduced, and the use forms of the Fresnel lens may be greatly increased.

The electromagnetic radiation sensing system according to the present disclosure will be illustrated below through specific examples.

### Embodiment 1

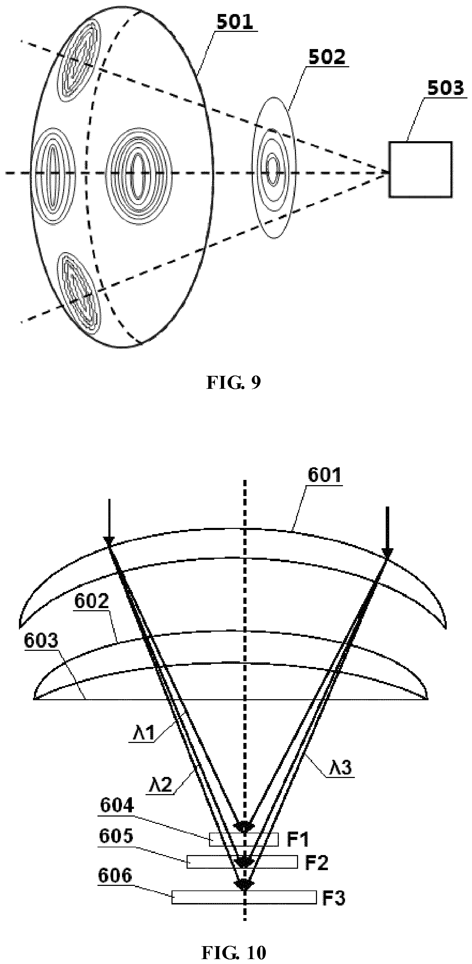

An embodiment of the electromagnetic radiation sensing system according to the present disclosure is shown in FIG. 9, which may include a sensing element 503 and a Fresnel lens system formed by two Fresnel lenses. The Fresnel lens system of the present embodiment may include two tooth sides. One tooth side 501 may be a composite Fresnel refraction surface, and the other tooth side 502 may include only one Fresnel unit. The dash lines in the figure may represent the optical axes of the Fresnel units. The two tooth sides may be arranged respectively on two separate single-sided elements to form one single-sided composite Fresnel lens and one single-sided simple Fresnel lens. The two single-sided lenses may be arranged successively on the light path in a tooth side to back side manner and used to collectively focus the signals to the sensing element 503. The composite Fresnel lens may be considered as the objective lens of the focusing system, while the simple Fresnel lens may be considered as the eyepiece. The lens system of the present embodiment may be used for detecting long distance signals, and may also be used for achieving graded condensing.

As a preferred embodiment, one or both of the two lenses may be driven by a motor. For example, the motor may drive the lens acting as the eyepiece to perform auto focus, or, the motor may further drive the lens acting as the objective lens to perform zooming, thereby making the electromagnetic radiation sensing system to become an automatic zoom system.

### Embodiment 2

Another embodiment of the electromagnetic radiation system according to the present disclosure is shown in FIG. 10, which may be a multi-focal plane sensing system and include three sensing elements and one three-toothed face Fresnel lens system. The first tooth side 601 may be a composite Fresnel refraction surface, and arranged on a single-sided element to form a single-sided composite Fresnel lens to perform the first focus on the light signals. The second tooth side and the third tooth side may be composite Fresnel refraction surfaces or may also include one Fresnel unit. For example, the second tooth side and the third tooth side may have the positional relationship as shown in FIG. 5 or FIG. 6. These two tooth sides may be arranged on the same element, or may also be arranged respectively on two single-sided elements. In the present embodiment, the second tooth side 602 and the third tooth side 603 may form, in a back-to-back manner, a double-sided Fresnel lens, and be used to perform the second focus on the light signals.

In the present embodiment, , the focusing system formed by the two lenses above may focus the light onto three different focal planes based on the central wavelength of different spectral bands, where the focal planes F1, F2 and F3 correspond to the central wavelength of three spectral bands λ1, λ2 and λ3. Each focal plane may be provided with a sensing element, such as the sensing elements 604, 605 and 606. The difference between the distances between adjacent focal planes may be not less than the thickness of the sensing element on the front focal plane so as to facilitate the stacked arrangement of a plurality of sensing elements. The front focal plane herein may refer to the focal plane with shorter focal length. Generally, the focal length of the lens is monotonically increasing with respect to the wavelength. In other words, the longer the center wavelength of the light, the farther the focal plane on which the light are converged. This relationship generally needs to be overcome in designing a traditional lens. However, in the present embodiment, this principle may be conformed and used to implement a multi-focal plane system and a multi-lens sensing system. For a person skilled in the art, the toothed face may be optically designed and applied with appropriate coating in order to better converge the light with different wavelength to the focal planes with different focal length, i.e. to separate the convergence positions of different spectral bands. Based on actual needs, the number of the focal planes may be 1 to 4. In the case that there is one focal plane, the affects of the wavelength to the focal length needs to be eliminated as much as possible, as the design of the traditional lens. While in the case that a plurality of focal planes are used, not only the optical design is easier, but also the light in different spectral bands can be better specially used and processed in different focal planes.

As a preferred embodiment, the sensitive sensing range of each sensing element may be adapted to the spectral band corresponding to the focal plane on which said sensing element is located, so as to achieve the best response to the wavelength in this spectral band, thereby maximally utilizing the energy of the incident electromagnetic radiation and effectively increasing the signal to noise ratio of the sensing system. Based on different materials and structural design thereof, the sensing element may have better response characteristic to the electromagnetic radiation in one or more certain wavelength ranges than to that in other wavelength range, such as better sensitivity or higher absorption and utilization efficiency, etc. Therefore, such ranges may be referred to as sensitive sensing ranges of the sensing element, or may also be referred to as best sensing ranges. As another preferred embodiment, the sizes of each sensing element may be adapted to the convergence area of the Fresnel lens system on the focal plane on which said sensing element is located. For example, in the case that there are a plurality of focal planes, the plurality of sensing elements with stacked arrangement may have an overall structure similar to the pyramid, i.e. the sensing element located on the focal plane with longer focal length may have larger area. The two preferred embodiments described above may be applied simultaneously or alternatively.

In the present embodiment, the sensing elements on the focal planes may be respectively implemented by separate devices (for example, photosensitive chips may be arranged on each focal plane, respectively), or may also be implemented by each layer of a multi-layer device. When the separate devices are used to achieve the sensing according to spectral bands, space may exist, or transparent materials may be filled, between the devices. In this case, the device which is located at front position on the light path may preferably be as thin as possible such that the electromagnetic waves can more easily pass through it to get to the device located at rear position. When each layer of the multi-layer device is used to act as the sensing element, the focal planes corresponding to different spectral bands may be designed to be located on different sensing layers of the multi-layer device by optically designing the Fresnel lens system. The multi-layer device herein may refer to the device with different sensing layers at different depths, such as multi-layer multi-spectral sensing chip made according to depth filtering principle. The multi-layer device may be single-sided, i.e. two or more stacked sensing layers are formed on one side of the substrate. The multi-layer device may also be double-sided, i.e. one or more sensing layers are formed on both sides of the substrate, respectively.

The sensing mode of the sensing element used in the present disclosure may be unidirectional sensing or bi-directional sensing, which can be selected and designed according to the requirements of specific application. The unidirectional sensing herein may refer to sensing the incident electromagnetic radiation from one direction of the element, such as the front side or the back side. The bi-directional sensing herein may refer to sensing the incident electromagnetic radiation from the front side and the back side of the element at the same or different time. In the case of bi-directional sensing, the Fresnel lens system with multiple faces as described above may be arranged on each direction.

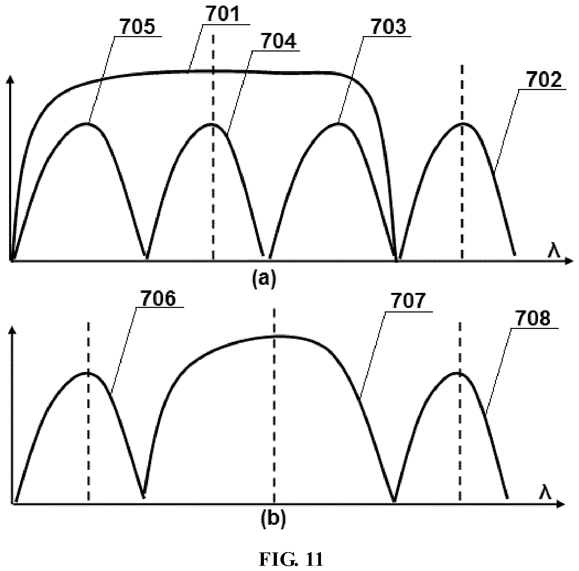

In the present embodiment, the sensing elements for corresponding spectral bands may be arranged on the focal planes to obtain the best response to the light with the wavelengths belonging to the spectral bands. Arranging different sensing elements on different focal planes may also achieve the maximize use of the incident light energy. Furthermore, the light in different spectral bands may be focused on different focal planes, which can facilitate multi-layer sensing. In the present embodiment, the three focal planes may correspond to three spectral bands divided. In other embodiments, the spectral range of interest may be divided into different sections according to the wavelength λ. The specific division may refer to the existing general rules, or may also be adjusted according to the requirements of the actual applications. FIG. 11 shows two common divisions. In one division, the spectrum may be divided into two sections: visible spectral band 701 and (near) infrared spectral band 702, referring to FIG. 11(a), where the dash lines represent the location of the central wavelength of the two sections. The visible spectral band 701 may include three spectral bands: red 703, green 704 and blue 705. In another division, the spectrum may be divided into three sections: ultraviolet spectral band 706, visible spectral band 707 and infrared spectral band 708, referring to FIG. 11(b), where the locations of the central wavelength of the three sections are similarly represented by dash lines.

The principles of the embodiment may also be used for designing the antenna in the field of modern wireless communication such that the antenna can simultaneously receive different frequency bands of signals, because the electromagnetic radiation sensing system according to the present disclosure is applicable to any spectrum of electromagnetic waves.

### Embodiment 3

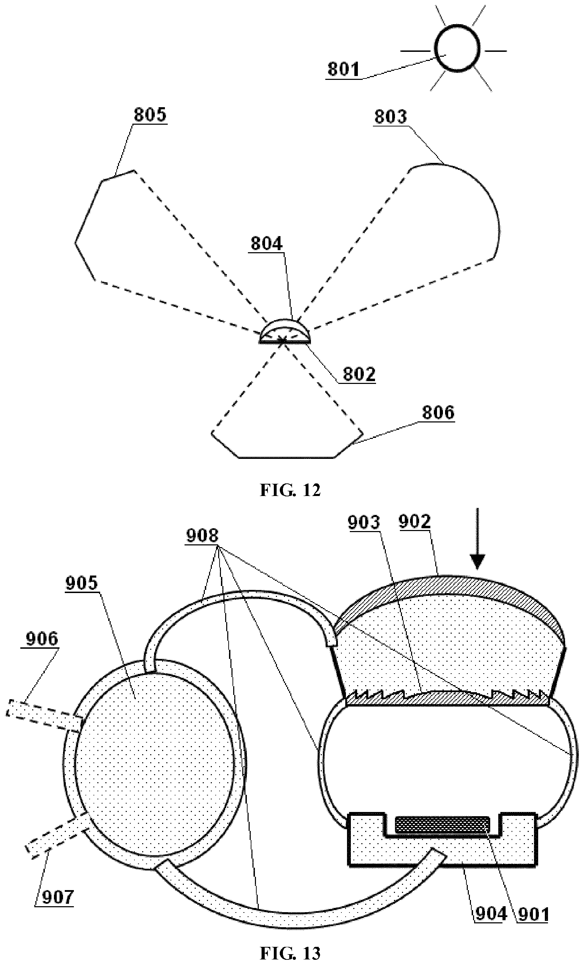

Another embodiment of the electromagnetic radiation sensing system according to the present disclosure is shown in FIG. 12, which may include a plurality of Fresnel lens systems. In FIG. 12, a radiation source 801 may be used to generate the electromagnetic radiation. The sensing element 802 may be a bi-directional sensing element, and be able to sense the electromagnetic radiation from both front and back directions at the same time. The Fresnel lenses 803 and 804 may be transmissive Fresnel lenses. For example, the Fresnel lens 803 may be a single-sided complex Fresnel lens so as to have larger sensing range, and the Fresnel lens 804 may be a double-sided Fresnel lens which may be formed by two toothed faces in a back-to-back manner so as to have strong convergence ability. The Fresnel lenses 805 and 806 may be reflective Fresnel lenses which may be formed by one toothed face and one reflective back face.

In the present embodiment, the combination of the lenses 803 and 804 may be considered as one Fresnel lens system, the combination of the lenses 805 and 804 may be considered as a second Fresnel lens system, and the lens 806 may be considered as a third Fresnel lens system. They may respectively converge the electromagnetic radiation in the sensing range of their own to the bi-directional sensing element 802 from different directions. Due to the use of the reflective Fresnel lens, the sensing range of the system can be greatly expanded, and the strength of the converged electromagnetic radiation can be increased by times. Furthermore, since the Fresnel lens is thin, the energy attenuation of the electromagnetic radiation passing through it is low. Therefore, the system of the present embodiment is particularly suitable for solar power generation and radar signal or space signal detection. For example, in the application of solar power generation, the radiation source 801 may be the sun, and the bi-directional sensing element 802 may be a photovoltaic panel, specifically a single-sided or double-sided photovoltaic panel. As a preferred embodiment, a simple method for manufacturing the single-sided bi-directional sensing element may be making the sensing element very thin such that the electromagnetic radiation (for example, the light) is able to get to the sensing region in the element from two directions. As another preferred embodiment, the double-sided sensing element may be obtained by simply stacking two single-sided sensing elements in a back-to-back manner.

In addition, in an embodiment, the toothed face of the reflective double-sided Fresnel lens may further preferably be filled Fresnel refraction surface, and may be formed by closely fitting two toothed faces which have complementary shapes. The fitting may be a fitting between solid toothed face and sold toothed face, or may also be a fitting between solid toothed face and liquid toothed face.

### Embodiment 4

Another embodiment of the electromagnetic radiation sensing system according to the present disclosure is shown in FIG. 13, which may include a sensing element 901, a Fresnel lens system formed by two Fresnel lenses 902 and 903, and a heat exchange system.

The lens 902 may be a single-sided Fresnel lens with outward toothed face, while the lens 903 may be a liquid filled Fresnel lens. Specifically, an enclosed space may be formed between the back face of the lens 902 and the toothed face of the lens 903, and liquid may be filled in the enclosed space.

The sensing element 901, as a heat dissipating end, may perform the heat exchange with the media of the heat exchange system through thermally conductive material. In the present embodiment, the sensing element may perform the heat exchange with the media through a cooling tank 904. In other embodiments, the sensing element may also be directly, or after being wrapped with thermally conductive material, soaked in the media of the heat exchange system.

The heat exchange system may include the cooling tank 904, a storage unit 905 for storing heat collection media and pipes 908 for communicating the various regions. The media for heat exchange may flow through the various regions through the pipes. In the present embodiment, the heat collection media may directly act as the media for heat exchange and flow between the various regions. In another embodiment, the heat collection media may be isolated from each other, may use the same or different substances, and may perform the heat exchange through the heat transfer structure in the storage unit.

When the sensing system is working, the incident electromagnetic radiation (as indicated by the arrow in the figure) may be focused on the sensing element through the Fresnel lens system. The media may enter the storage unit through the flow inlet 906, and may, due to the principle of liquid thermal convection (the hot media will go up), flow into the cooling tank of the sensing element through the communication pipe so as to perform the heat exchange with the sensing element. Then, the media may enter the enclosed space between the lens 902 and the lens 903 through the communication pipe so as to perform the heat exchange with the lenses and act as filling liquid, and then go back to the storage unit through the communication pipe. Finally, the media may flow out through the flow outlet 907. The above description of the heat exchange process is only exemplary. Based on the needs of practical applications, the regions through which the media flows may be added or reduced. For example, the space for filling of the filled Fresnel lens may be completely closed and the media does not act as the filling liquid. In actual use, the system may further include automatic valves, pressure control system, temperature control system or the like.

The electromagnetic radiation sensing system of the present embodiment may be used as a household solar power generation and water heating system, where the sensing element may be photovoltaic panels, the media of the heat exchange system may be the water, and the storage unit may be a hot water tank. One portion of the incident sunlight may be converted into electrical energy, and other portion may be converted into thermal energy. The generated thermal energy may be absorbed through the heat exchange system for heating the water. Therefore, the utilization rate of the solar energy is increased, and the energy needed for household water heating is correspondingly reduced. In this case, the water flowing in through the flow inlet 906 is clod water, and the water flowing out through the flow outlet 907 is hot water available for household use.

The electromagnetic radiation sensing system of the present disclosure may also be used as a infrared night vision system with cooling system, where the sensing element may be the infrared photosensitive chip, the storage unit may be a cooler, and the media acting as coolant may, when flowing through the lens space and the cooling tank in which the sensing element is arranged, cool them. In the application of the infrared night vision system, in order to reduce the impact of the thermal radiation of the surrounding objects (including the shot (lens)) on the sensing element, generally the lens and the sensing element need to be cooled to a temperature much more lower than the observed object. In traditional infrared night vision system, the traditional lenses are used, and the thickness is large. Furthermore, the cooling is generally performed externally, therefore the cooling rate is low and a long pre-cooling is necessary before the system is used. However, in the infrared night vision system using the configuration of the present embodiment, not only the lenses are thin, but also the cooling is performed internally such that the cooling rate is greatly increased and the signal to noise ratio of the sensing element can be effectively improved. Furthermore, the liquid filled Fresnel lens used is further able to provide high quality imaging. In addition, in some applications, conversely, the lens and the sensing element may be heated through the heat exchange system based on needs.

The principles and embodiments of the present disclosure have been described with reference to specific examples. It should be understood that the embodiments above are merely used to facilitate the understanding to the present disclosure, but should not be construed as limiting the present disclosure. For a person ordinarily skilled in the art, modifications to the specific embodiments described above may be made according to the concepts of the present disclosure.

## Claims

1. An electromagnetic radiation sensing system, comprising a sensing element and a Fresnel lens system used for converging electromagnetic radiation, wherein, the sensing element is used to sense the electromagnetic radiation converged by the Fresnel lens system,
the Fresnel lens system comprises at least tow toothed faces located on a same light path, wherein each toothed face comprises at least one Fresnel unit and each Fresnel unit is a Fresnel refraction surface generated from one original curved surface,
at least one of the two toothed faces is a complex Fresnel refraction surface or a filled Fresnel refraction surface, or
the two toothed faces are a same physical interface and an element on which the two toothed faces are located has a reflective back face.

2. The electromagnetic radiation sensing system of claim 1, wherein, the original curved surface is a coaxial surface whose focuses are located on a same straight line, and the coaxial surface comprises rotation quadratic surface, rotation higher order polynomial surface, cylindrical surface and tapered surface.

3. The electromagnetic radiation sensing system of claim 1, wherein, the Fresnel units of each tooth side have a common back side, and the back side is formed as a macroscopic surface.

4. The electromagnetic radiation sensing system of claim 3, wherein the macroscopic surface is selected from plane, coaxial surface, multi-plane surface formed by splicing a plurality of planes and trapezoidal table surface.

5. The electromagnetic radiation sensing system of any one of claims 1 to 4, wherein Fresnel lens units on a same tooth side focus light in a same spectral band to a same point, or a straight line, or a limited area.

6. The electromagnetic radiation sensing system of any one of claims 1 to 4, wherein, the Fresnel lens system converges the electromagnetic radiation to corresponding focal planes according to center wavelength of different spectral bands, a number of the focal planes is 1 to 4, each focal plane is provided with a sensing elements, and a difference between distances between adjacent focal planes is not less than a thickness of the sensing element on a front focal plane.

7. The electromagnetic radiation sensing system of claim 6, wherein the longer the focal length of the focal plane, the longer the corresponding central wavelength.

8. The electromagnetic radiation sensing system of claim 7, wherein, a sensitive sensing range of each sensing element is adapted to a spectral band corresponding to the focal plane on which said sensing element is located, and/or, a size of each sensing element is adapted to a convergence area of the Fresnel lens system on the focal plane on which said sensing element is located.

9. The electromagnetic radiation sensing system of claim 7 or 8, wherein, the sensing elements on the focal planes are respectively implemented by separate devices, and space exists between the separate devices or a transparent material is filled between the separate devices; or, the sensing elements on the focal planes are respectively implemented by each layer of a multi-layer device,
a sensing mode of the sensing element is unidirectional sensing or bi-directional sensing.

10. The electromagnetic radiation sensing system of any one of claims 1 to 9, wherein, the two tooth sides are both composite Fresnel refraction surface, and the Fresnel units on the two composite Fresnel refraction surfaces are the same in number and arranged concentrically, or, the Fresnel units on the two composite Fresnel refraction surfaces are different in number and arranged in a staggered manner, wherein staggered arrangement preferably has equal stagger distances.

11. The electromagnetic radiation sensing system of claim 1, wherein filling material of the filled Fresnel refraction surface is selected from solid, liquid or gas, wherein the solid is preferably selected from acrylic, plastic and resin, the liquid is preferably water, and the gas is preferably inert gas.

12. The electromagnetic radiation sensing system of any one of claims 1 to 11, wherein, the Fresnel lens system comprises a double-sided Fresnel lens, and the double-sided Fresnel lens is formed by one toothed face and one reflective back face, or
the double-sided Fresnel lens is formed by two toothed faces in a back-to-back manner.

13. The electromagnetic radiation sensing system of claim 1, wherein, the two tooth sides are arranged on two separate elements, respectively, and one of the two separate elements is driven by a motor to perform an auto focus and/or the other of the two separate elements is driven by a motor to perform zooming.

14. The electromagnetic radiation sensing system of any one of claims 1 to 13, further comprising a heat exchange system, wherein, the sensing element, as a heat dissipating end, is directly soaked in a media of the heat exchange system, or, the sensing element performs heat exchange with a media of the heat exchange system through a thermally conductive material.

15. The electromagnetic radiation sensing system of claim 14, wherein, the sensing element is a solar photovoltaic panel, and the heat exchange system is used as a water heating system; or, the sensing element is a infrared photosensitive chip, and the heat exchange system is used as a cooling system.
